# EUROPÄISCHE PATENTSCHRIFT

(11) **EP 3 232 573 B1**
(45) Veröffentlichungstag und Bekanntmachung des Hinweises auf die Patenterteilung: **24.07.2019**
(21) Anmeldenummer: 17000217.4
(22) Anmeldetag: 06.05.2013
(51) Int. Cl.: H03M 5/12

(54) **DEKODIERUNGSVERFAHREN UND DEKODIEREINRICHTUNG**
DECODING METHOD AND DECODING APPARATUS
PROCÉDÉ DE DÉCODAGE ET DÉCODEUR

(30) Priorität: 29.05.2012 DE 102012010375
(43) Veröffentlichungstag der Anmeldung: 18.10.2017
(62) Teilanmeldung aus: 13722285.7
(73) Patentinhaber: SEW-EURODRIVE GmbH & Co. KG, 76646 Bruchsal (DE)
(72) Erfinder: Simon, Olaf, 76646 Bruchsal Untergrombach (DE); Quadt, Steffen, 76139 Karlsruhe (DE); Müller, Michael, 76689 Karlsdorf-Neuthard (DE); Hoffmann, Julian, 67729 Sippersfeld (DE)

(56) Entgegenhaltungen:
- EP-A2- 0 168 770
- EP-A2- 1 528 738
- JP-A- H11 177 638
- US-A1- 2010 208 849
- US-B1- 6 370 212

## Beschreibung

Die Erfindung betrifft ein Dekodierungsverfahren und eine Dekodiereinrichtung.

Die Manchester-Kodierung dient der Übertragung von Signalen von einem Sender zu einem Empfänger. In der Regel liegt der Sendedatenstrom in Form eines Daten-Signals und eines Clock-Signals vor. Um die Übertragung von zwei Signalen vom Sender zum Empfänger zu vermeiden, wird aus dem Clock-Signal und dem Datensignal ein Manchester-kodiertes Signal generiert. Damit ist es möglich, den Datenstrom über eine gemeinsame Signalleitung an den Empfänger zu übertragen. Da der Empfänger zur weiteren Verarbeitung jedoch ebenfalls wieder ein Clock-Signal und ein Daten-Signal benötigt, muss das Manchester-kodierte Signal wieder dekodiert werden. Diese Dekodierung erfordert die Rückgewinnung des Clock-Signals aus dem gesendeten Signal.

Bei den im Stand der Technik bekannten Dekodie-rungsverfahren synchronisiert sich der Empfänger im einfachsten Fall auf das erste empfangene Startbit auf und wertet alle folgenden Bits jeweils zur halben a priori bekannten Bitzeit aus. Damit auch noch das letzte Bit korrekt ausgelesen werden kann, darf die Zeitbasis des Empfänger nach dem letzten übertragenen Bit maximal um die halbe Bitzeit abgewichen sein. Das Manchester-kodierte Signal muss also mit einer Frequenz abgetastet werden, die für typische Anwendungsfälle nur um 0,2 % von der Sendefrequenz abweichen darf. Diese Anforderung ist nur mit großem Aufwand zu erfüllen und in jedem Fall relativ störanfällig.

Bekannte Dekodierungsverfahren setzen daher auf Phasenregelschleifen (Phase-Locked-Loop, PLL), die aufgrund der auftretenden Signalflanken im Eingangssignal kontinuierlich die Abtastfrequenz des Empfängers derart nachführen, dass diese möglichst synchron zur Senderfrequenz gehalten wird. Auf diese Weise wird das Clock-Signal des Senders rekonstruiert. Nachteile von Verfahren, die ein synchronisiertes Clock-Signal für die Abtastung des Eingangssignals erzeugen, liegen jedoch darin, dass Störungen auf dem Eingangssignal möglicherweise in den Abtastzeitpunkt fallen und somit Fehler in der Dekodierung verursachen. Ein Beispiel für die einmalige Abtastung des Eingangssignals innerhalb einer halben Bitzeit ist in US 4 881 059 A zu finden.

Ein weiterer Nachteil der PLLs besteht darin, dass es sich um eine rückgeführte beziehungsweise geregelte Struktur handelt, die bis zur gewünschten Funktion eine Einschwingzeit durchlaufen muss und deren Auslegung der Regelparameter auf mögliche Instabilitäten hin optimiert sein muss. Insbesondere bei kurzen Telegrammen, die jeweils mit einer zeitlichen Unterbrechung gesendet werden, führt dies dazu, dass jeweils eine neue Einschwingphase hervorgerufen wird. Dies kann dazu führen, dass der Beginn eines jeden Telegramms möglicherweise nicht korrekt dekodiert werden kann.

In US 7 133 482 B2 ist ein Verfahren beschrieben, mit dem die beschriebenen Nachteile vermieden werden soll. Dabei wird eine zweistufige Signalauswertung vorgenommen. In einer ersten Stufe wird das Empfangssignal gefiltert, so dass Störungen das nachgeschaltete Auswerteverfahren nicht negativ beeinflussen können. Die Auswertung erfolgt nachgelagert dadurch, dass das gefilterte Eingangssignal zu festgelegten Zeitpunkten nach der letzten erkannten Flanke ausgewertet wird, wodurch ohne PLL eine kontinuierliche Anpassung an den Takt des Senders erfolgt. Als Eingangsfilter wird ein bereichsbegrenzter Integrator verwendet.

In US 5 696 800 wird ein Verfahren beschrieben, bei dem die Fehlertoleranz durch die Erzeugung von zwei Clock-Signalen erreicht wird, die mit Filtern verschiedener Bandbreiten erzeugt werden. Hierdurch entstehen jedoch aufwendige Strukturen.

In US 6 370 212 B1 wird für die Auswertung des Manchester-kodierten Signals die Verwendung eines gleitenden Mittelwertfilters eingeführt. Diese Implementierung generiert das dekodierte Clock-Signal jedoch nach wie vor aus einer dem gleitenden Mittelwertfilter nachgeschalteten Phasenregelschleife. Hierdurch kann ein eingehendes Signal erst ab dem Zeitpunkt ausgewertet werden, ab dem die Phasenregelschleife auch synchronisiert ist. Damit ist die komplette Dekodierung kurzer Signalfolgen nicht möglich. Weiterhin werden Transitionspunkte als Eingangssignal für die Phasenregelschleife generiert. Da dieses Signal aus dem ersten Steigungswechsel abgeleitet wird, können sich bei gestörten Eingangssignalen deutliche zeitliche Abweichungen ergeben, die die Entscheidung erschweren, ob die Phasenregelschleife eingerastet ist und damit die dekodierten Signal gültig sind. Es wird daher nur eine begrenzte Störunempfindlichkeit erreicht.

Aus US 2010/0208849 A1 sind ein Empfangsschaltkreis, dessen Verwendung und ein Verfahren zum Empfang eines kodierten und modulierten Radiosignals bekannt, wobei über einen Umschalter alternativ zwei Signale einer Phasenregelschleife zur Regenerierung eines Clocksignals zugeführt werden. Das Eingangssignal für die Phasenregelschleife wird aus einem gleitenden Mittelwert über eine die Taktdauer T/2 gewonnen. Die dekodierten Manchester Daten werden aus einem gleitenden Mittelwert über die Symboldauer T gewonnen.

Aus EP 1 528 738 A2 sind ein Amplitudenumtastungs-Demodulationsgerät und ein drahtloses Gerät zu dessen Verwendung bekannt, wobei eine Clock-Extraktionseinheit detektiert, dass ein Nulldurchgangs-Zeitintervall gleich einer Bit-Zeit ist, und eine Clock-Wiederherstellungseinheit ein richtiges Daten-Clock-Signal durch Synchronisation mit einem vorhandenen Daten-Clock-Signal wiederherstellt.

Aus der JP 11-177638 ist eine logische Schaltung zur Dekodierung von Manchester kodierten Eingangsdaten bekannt, wobei ein Ausgang D für die dekodierten Daten und ein Ausgang C für ein regeneriertes Clock-Signal vorgesehen sind, und wobei das regenerierte Clock-Signal aus einer XOR Verknüpfung der dekodierten Daten und der empfangenen Manchester kodierten Daten gewonnen wird.

Der Erfindung liegt die Aufgabe zugrunde, ein Dekodierungsverfahren weiterzubilden, welches die Verarbeitung kurzer Telegramme von Manchester-kodierten Signalen erlaubt.

Erfindungsgemäß wird die Aufgabe bei dem Dekodierungsverfahren mit den in Anspruch 1 angegebenen Merkmalen und bei der Dekodiereinrichtung mit den in Anspruch 12 angegebenen Merkmalen gelöst.

Wichtige Merkmale der Erfindung eines Dekodierungsverfahrens für ein Manchester-kodiertes Signal sind, dass für das Manchester-kodierte Signal ein gleitender Daten-Mittelwert mit einer Daten-Mittelwertzeit gebildet wird und dass aus dem gleitenden Daten-Mittelwert mit einem Daten-Komparator ein dekodiertes Daten-Signal gebildet und bereitgestellt wird. Von Vorteil ist dabei, dass nur Bauelemente erforderlich sind, die vergleichsweise kurze Einschwingzeiten aufweisen. Somit sind kurze Daten-Telegramme in Manchester-Kodierung verarbeitbar.

Erfindungsgemäß ist ferner vorgesehen, dass für das Manchester-kodierte Signal ein gleitender Clock-Mittelwert mit einer Clock-Mittelwertzeit gebildet wird und dass zumindest aus dem gleitenden Clock-Mittelwert mit einem Clock-Komparator ein Clock-Signal gebildet und bereitgestellt wird. Weitere Signale können zur Bildung des dekodierten Clock-Signals verarbeitet werden. Von Vorteil ist dabei, dass eine Phasenreglungsschleife nicht erforderlich ist. Auch die Kenntnis der Bitzeit des Clock-Signals ist nicht erforderlich, sondern diese kann aus dem rekonstruierten Clock-Signal abgeleitet werden.

Erfindungsgemäß ist weiter vorgesehen, dass zur Bildung des Clock-Signals ein Ausgangssignal des Clock-Komparators mit einem Ausgangssignal des Daten-Komparators logisch verknüpft wird. Bevorzugt wird das Ausgangssignal des Clock-Komparators mit dem Ausgangssignal des Daten-Komparators, insbesondere dem Daten-Signal, verknüpft. Besonders günstig ist es, wenn die genannten Ausgangssignale durch XOR-Verknüpfung logisch verknüpft werden. Von Vorteil ist dabei, dass ein einfaches Verfahren angegeben ist, mit welchem das Clock-Signal rekonstruierbar ist. Phasenregelschleifen sind verzichtbar, so dass kurze Einschwing- und Ansprechzeiten erreichbar sind. Diese Ausgestaltung ist mit Vorteil bei einer Ausgestaltung einsetzbar, bei welcher in der beschriebenen Art ein Daten-Signal und ein Clock-Signal gebildet werden. Bei einer vorteilhaften Ausgestaltung kann vorgesehen sein, dass die Clock-Mittelwertzeit kürzer als die Daten-Mittelwertzeit ist. Somit ist das geringfügig gegenüber dem Daten-Signal höherfrequente Clock-Signal leicht abtrennbar.

Bei einer vorteilhaften Ausgestaltung kann vorgesehen sein, dass zur Bildung des gleitenden Daten-Mittelwerts des gleitenden Clock-Mittelwerts ein aus dem Manchester-kodierten Signal abgeleitetes Signal über die Daten Clock- Mittelwertzeit integriert wird. Es kann somit vorgesehen sein, dass einzelne oder alle der aufgeführten Mittelwerte durch Integration gewonnen werden. Die Integration stellt ein einfaches Mittel dar, um die Mittelwerte zu berechnen.

Bei einer vorteilhaften Ausgestaltung kann vorgesehen sein, dass zur Bildung des gleitenden Daten- und/oder Clock-Mittelwerts fortschreitend ein Differenzsignal von Differenzen zwischen jedem Symbol des Manchester-kodierten Signals und einem zu diesem Symbol um eine vorgegebene Zeitdauer zeitversetzten Symbol der Manchester-kodierten Signalfolge als das aus dem Manchester-kodierten Signal abgeleitete Signal gebildet wird. Von Vorteil ist dabei, dass auf einfache Weise ein abgeleitetes Signal bereitstellbar ist und bereitgestellt wird, aus welchem durch Integration oder auf andere Weise ein gleitender Mittelwert bildbar ist.

Bei einer vorteilhaften Ausgestaltung kann vorgesehen sein, dass der Daten-Komparator den gleitenden Daten-Mittelwert mit wenigstens einem Daten-Schwellwert vergleicht und das dekodierte Daten-Signal in Abhängigkeit von einem Überschreiten oder Unterschreiten des wenigstens einen Daten-Schwellwerts ausgibt. Von Vorteil ist dabei, dass mit dem Daten-Komparator auf einfache Weise aus dem feinstufigen oder analogen gleitenden Daten-Mittelwert ein binäres Signal gewinnbar ist.

Bei einer vorteilhaften Ausgestaltung kann vorgesehen sein, dass der wenigstens eine Daten-Schwellwert einen unteren Daten-Schwellwert und einen oberen Daten-Schwellwert umfasst und dass der Daten-Komparator das dekodierte Signal in Abhängigkeit von einem Überschreiten des oberen Daten-Schwellwerts und/oder einem Unterschreiten des unteren Daten-Schwellwerts ausgibt. Von Vorteil ist dabei, dass auf diese Weise ein Hystereseverhalten des Daten-Komparators abbildbar ist. Dies ist besonders günstig für die Erzeugung des binären Signals, da im Übergangsbereich der Schwellwerte ein zu häufiges Umschalten vermieden werden kann.

Bei einer vorteilhaften Ausgestaltung kann vorgesehen sein, dass der untere Daten-Schwellwert gleich dem oberen Clock-Schwellwert oder größer als der obere Clock-Schwellwert ist. Hierbei ergibt sich eine besonders günstige Trennung des Daten-Signals von dem Clock-Signal.

Bei einer vorteilhaften Ausgestaltung kann vorgesehen sein, das ein arithmetischer Mittelwert des unteren Daten-Schwellwerts und des oberen Daten-Schwellwerts zwischen Null und Eins, insbesondere zwischen 0,3 und 0,7 oder bei 1/2 liegt. Es hat sich herausgestellt, dass die symmetrische Anordnung des arithmetischen Mittelwerts und/oder des unteren und des oberen Schwellwerts in Bezug auf die Grenzen 0 und 1 besonders günstig für die Extraktion des Datensignals ist.

Bei einer vorteilhaften Ausgestaltung kann vorgesehen sein, dass als Daten-Mittelwertzeit eine Zeitdauer, die größer als eine halbe Bitzeit eines Clock-Signals des Manchester-kodierten Signals ist, eingerichtet wird. Es kann auch vorgesehen sein, dass als Daten-Mittelwertzeit eine Zeitdauer, die kleiner als das 1,5fache der Bitzeit eines Clock-Signals des Manchester-kodierten Signals ist. Werden diese Bereichsgrenzen kombiniert, so ergibt sich als vorteilhafte Ausgestaltung, dass als Daten-Mittelwertzeit eine Zeitdauer, die zwischen einer halben Bitzeit und dem 1,5fachen der Bitzeit des Clock-Signals des Manchester-kodierten Signals liegt, gewählt ist. Es hat sich herausgestellt, dass für diese Werte besonders robuste Dekodierungen des Daten-Signals erreichbar sind. Besonders günstig ist es, wenn als Daten-Mittelwertzeit eine Zeitdauer, die zwischen dem 0,8fachen und dem 1,2fachen der Bitzeit des Clock-Signals liegt, insbesondere die gleich der Bitzeit des Clock-Signals ist, eingerichtet wird.

Bei einer vorteilhaften Ausgestaltung kann vorgesehen sein, dass als Clock-Mittelwertzeit eine Zeitdauer, die kleiner als eine Bitzeit, eines Clock-Signals des Manchester-kodierten Signals ist, eingerichtet wird. Von Vorteil ist dabei, dass auf diese Weise ein Filter für gegenüber dem Daten-Signal vergleichsweise höhere Frequenzen bildbar ist, mit welche das Clock-Signal enthalten. Besonders günstig ist es, wenn als Clock-Mittelwertzeit eine Zeitdauer, die zwischen dem 0,3fachen und dem 0,7fachen der Bitzeit des Clock-Signals liegt, insbesondere die gleich der halben Bitzeit eines Clock-Signals des Manchester-kodierten Signals ist, eingerichtet wird.

Bei einer vorteilhaften Ausgestaltung kann vorgesehen sein, dass der Clock-Komparator den gleitenden Clock-Mittelwert mit wenigstens einem Clock-Schwellwert vergleicht und ein Ausgabesignal in Abhängigkeit von einem Überschreiten oder Unterschreiten des wenigstens einen Clock-Schwellwerts ausgibt. Von Vorteil ist dabei, dass ein binäres Signal aus dem feinstufigen oder analogen gleitenden Clock-Mittelwert bildbar und bereitstellbar ist.

Bei einer vorteilhaften Ausgestaltung kann vorgesehen sein, dass der wenigstens eine Clock-Schwellwert einen unteren Clock-Schwellwert und einen oberen Clock-Schwellwert umfasst und dass der Clock-Komparator ein Ausgabesignal in Abhängigkeit von einem Überschreiten des oberen Clock-Schwellwerts und/oder einem Unterschreiten des unteren Clock-Schwellwerts ausgibt. Von Vorteil ist dabei, dass ein Hystereseverhalten an dem Clock-Komparator realisierbar ist. Hierdurch ist eine besonders störunempfindliche Erzeugung eines Clock-Signals erreichbar.

Bei einer vorteilhaften Ausgestaltung kann vorteilhaft sein, dass ein arithmetischer Mittelwert des unteren Clock-Schwellwerts und des oberen Clock-Schwellwerts zwischen Null und Eins liegt oder gewählt wird. Besonders günstig ist es, wenn der arithmetische Mittelwert des unteren Clock-Schwellwerts und des oberen Clock-Schwellwerts unterhalb des arithmetischen Mittelwerts von unterem Daten-Schwellwert und oberem Daten-Schwellwert liegt. Besonders bevorzugt ist es, wenn der arithmetische Mittelwert des unteren Clock-Schwellwerts und des oberen Clock-Schwellwerts zwischen 0,2 und 0,3 oder bei 1/4 liegt. Es hat sich herausgestellt, dass für die angegebenen Zahlenwerte besonders robuste Dekodierungsverfahren bildbar sind.

Die hier und in der gesamten Beschreibung angegebenen Signalstärken, insbesondere für Schwellwerte und Mittelwerte, sind bevorzugt jeweils auf die Flankenhöhe des Manchester-kodierten Signals bezogen.

Bei einer vorteilhaften Ausgestaltung kann vorgesehen sein, dass der gleitende Daten- und/oder Clock-Mittelwert gleichzeitig und/oder zeitlich parallel zueinander gebildet wird/werden. Von Vorteil ist dabei, dass ein besonders schnelles Dekodierungsverfahren bereitstellbar ist, mit welchem die eingehenden Daten in Echtzeit dekodierbar sind.

Bei einer vorteilhaften Ausgestaltung kann vorgesehen sein, dass der gleitende Daten- und/oder Clock-Mittelwert mit einer Sampling-Rate gebildet wird/werden, die jeweils kleiner als die oder eine Bitzeit des oder eines Clock-Signals des Manchester-kodierten Signals ist. Von Vorteil ist dabei, dass eine feinstufige Bildung des jeweiligen Mittelwerts möglich ist. Bevorzugt ist vorgesehen, dass die Sampling-Rate kleiner als 1/10 oder sogar als 1/100 der Bitzeit des Clock-Signals ist. Bevorzugt beträgt die Sampling-Rate 1/256 der Bitzeit.

Bei einer vorteilhaften Ausgestaltung kann vorgesehen sein, dass der gleitende Daten- und/oder Clock-Mittelwert zeitgleich zu einer Bereitstellung weiterer Symbole des Manchester-kodierten Signals gebildet wird/werden. Von Vorteil ist dabei, dass die dekodierte Information bereits bereitstellbar und weiterverarbeitbar ist, wenn das Telegramm noch nicht vollständig empfangen ist.

Die beschriebenen Verfahrensschritte zur Bildung des Daten-Signals und des Clock-Signals sind bei weiteren Ausführungsbeispielen miteinander kombiniert. Beispielsweise ist bei einer vorteilhaften Ausgestaltung vorgesehen, dass in der beschriebenen Art und Weise ein Daten-Signal und ein Clock-Signal gebildet werden.

Wichtige Merkmale der Erfindung einer Dekodiereinrichtung mit einem Signaleingang für ein Manchester-kodierbares Signal und einem Daten-Signalausgang für ein aus dem Manchester-kodierten Signal dekodiertes Daten-Signal sind, dass ein Daten-Signalflussweg vom Signaleingang zu einem gleitenden Daten-Mittelwertbilder, von diesem zu einem Daten-Komparator und von diesem zu dem Daten-Signalausgang eingerichtet ist. Hierbei bezeichnet ein Signalflussweg den Weg, den die Signale bei der Verarbeitung, beispielsweise nach dem erfindungsgemäßen Dekodierungs-verfahren, durch die Dekodiereinrichtung nehmen. Von Vorteil ist dabei, dass eine Dekodiereinrichtung bereitgestellt ist, mit welcher ein erfindungsgemäßes Dekodierverfahren ausführbar ist, bei welchem ein dekodiertes Daten-Signal bereitgestellt wird. Hierbei kann der gleitende Daten-Mittelwertbilder zur Bildung eines gleitenden Daten-Mittelwerts eingerichtet sein. Unter einem Komparator wird allgemein eine Vergleichsschaltung verstanden, welche ein Eingangssignal mit einem vorgegebenen Signal, beispielsweise einem Schwellwert, oder einem weiteren Eingangssignal, beispielsweise einem veränderlichen Schwellwert, vergleicht und das Ergebnis dieses Vergleichs als Ausgangssignal ausgibt.

Zusätzlich ist vorgesehen, dass die Dekodiereinrichtung mit einem Signaleingang für ein Manchester-kodierbares Signal und einem Daten-Signalausgang für ein aus dem Manchester-kodierten Signal dekodiertes Daten-Signal ausgerüstet ist und dass ein Clock-Signalflussweg vom Signaleingang zu einem gleitenden Clock-Mittelwertbilder, von diesem zu einem Clock-Komparator und von diesem zu einem Clock-Signalausgang eingerichtet ist. Von Vorteil ist dabei, dass bei der Bildung des Clock-Signals Phasenregelschleifen verzichtbar sind. Es sind so kurze Einschwingzeiten erreichbar.

Besonders günstig ist es, wenn die erfindungsgemäße Dekodiereinrichtung wenigstens zwei oder drei Signalflusswege aus der Gruppe von Daten-Signalflussweg und Clock-Signalflussweg aufweist. Für viele Zwecke ist es bereits ausreichend, wenn in der erfindungsgemäßen Dekodiereinrichtung ein Daten-Signalflussweg und ein Clock-Signalflussweg in der beschriebenen Weise ausgebildet sind.

Bei einer vorteilhaften Ausgestaltung kann vorgesehen sein, dass mit dem gleitenden Daten-Mittelwertbilder ein gleitender Mittelwert des Manchester-kodierten Signals über eine Daten-Mittelwertzeit bildbar ist. Von Vorteil ist dabei, dass ein Mittelwertbilder ein praktikables Werkzeug darstellt, mit welchem ein gleitender Mittelwert schnell und in Echtzeit bildbar ist.

Bei einer vorteilhaften Ausgestaltung kann vorgesehen sein, dass mit dem gleitenden Clock-Mittelwertbilder ein gleitender Mittelwert eines aus dem Manchester-kodierten Signal abgeleiteten Signals über einen Clock-Mittelwertzeit bildbar ist. Von Vorteil ist dabei, dass der im Verfahren benötigte gleitende Clock-Mittelwert einfach bildbar ist.

Die hierbei verwendeten Mittelwertzeiten sind vorzugsweise wie zuvor zum Dekodierungsverfahren beschrieben gewählt.

Erfindungsgemäß ist vorgesehen, dass eine Verknüpfungseinrichtung zur logischen Verknüpfung eines Ausgangssignals des Daten-Komparators mit einem Ausgangssignal des Clock-Komparators eingerichtet ist. Hierbei kann vorgesehen sein, dass der Clock-Signalflussweg von einem Signalausgang der Verknüpfungseinrichtung zu dem Clock-Signalausgang geführt ist. Von Vorteil ist dabei, dass ein einfaches Verfahren, das Clock-Signal ohne Phasenregelschleife zu rekonstruieren oder dekodieren, realisierbar ist. Bevorzugt realisiert die Verknüpfungseinheit eine XOR-Verknüpfung.

Bei einer vorteilhaften Ausgestaltung kann vorgesehen sein, dass die Mittelwertbilder zur Bildung oder Berechnung eines Differenzsignals eingerichtet sind, wobei das Differenzsignal symbolweise die Differenz von Symbolen des Manchester-kodierten Signals zu einem zu dem jeweiligen Symbol um eine vorgegebene Zeitdauer zeitversetzten Symbol ausdrückt. Von Vorteil ist dabei, dass ein aus dem Manchester-kodierten Signal abgeleitetes Signal bereitgestellt ist, welches zur Mittelwertbildung durch Integration oder auf andere Weise weiterverarbeitbar ist.

Bei einer vorteilhaften Ausgestaltung kann vorteilhaft sein, dass der Daten-Komparator zur Ausgabe eines Ausgangssignals in Abhängigkeit von einem Überschreiten oder Unterschreiten wenigstens eines Daten-Schwellwerts, insbesondere zur Ausgabe eines Ausgangssignals in Abhängigkeit von einem Überschreiten eines oberen Daten-Schwellwerts des wenigstens einen Daten-Schwellwerts und/oder einem Unterschreiten eines unteren Daten-Schwellwerts des wenigstens einen Daten-Schwellwerts, eingerichtet ist. Von Vorteil ist dabei, dass ein einfaches Mittel zur Erzeugung eines binären Daten-Signals ausgebildet ist. Durch die Ausbildung eines oberen Daten-Schwellwerts und separaten eines unteren Daten-Schwellwerts ist eine Hysterese bei der Umwandlung in ein binäres Signal realisierbar, welche ein zu häufiges Umschalten aufgrund von Störungen unterdrückt.

Bei einer vorteilhaften Ausgestaltung kann vorgesehen sein, dass der Clock-Komparator zur Ausgabe eines Ausgangssignals in Abhängigkeit von einem Überschreiten oder Unterschreiten wenigstens eines Clock-Schwellwerts, insbesondere zur Ausgabe eines Ausgangssignals in Abhängigkeit von einem Überschreiten eines oberen Clock-Schwellwerts des wenigstens einen Clock-Schwellwerts und/oder einem Unterschreiten eines unteren Clock-Schwellwerts des wenigstens einen Clock-Schwellwerts, eingerichtet ist. Von Vorteil ist dabei, dass ein weiterverarbeitbares, binäres Ausgangssignal bereitgestellt ist.

Bei einer vorteilhaften Ausgestaltung kann vorgesehen sein, dass die Komparatoren jeweils als Schmidt-Trigger ausgebildet sind.

Bei einer vorteilhaften Ausgestaltung kann vorgesehen sein, dass die Dekodiereinrichtung zur gleichzeitigen und/oder zeitlich parallelen Bildung der gleitenden Daten- und/oder Clock-Mittelwerte eingerichtet ist. Von Vorteil ist dabei, dass eine parallele Verarbeitung zeitsparend ausführbar ist.

Bei einer vorteilhaften Ausgestaltung kann vorgesehen sein, dass der gleitende Daten- und/oder Clock-Mittelwert mit einer Sampling-Rate bildbar ist/sind, die jeweils kleiner als die oder eine Bitzeit, insbesondere kleiner als 1/10 oder 1/100, des oder eines Clock-Signals des Manchester-kodierten Signals ist. Von Vorteil ist dabei, dass eine feinstufige Abtastung des empfangenen Manchester-kodierten Signals möglich ist.

Bei einer vorteilhaften Ausgestaltung kann vorgesehen sein, dass die Dekodiereinrichtung zur zeitgleichen Bildung des gleitenden Daten- und/oder Clock-Mittelwerts mit der Bereitstellung weiterer Symbole des Manchester-kodierten Signals eingerichtet ist. Von Vorteil ist dabei, dass das dekodierte Daten-Signal bereitstellbar ist, bevor die Manchester-kodierte Nachricht vollständig empfangen ist.

Weitere Vorteile ergeben sich aus den Unteransprüchen. Die Erfindung ist nicht auf die Merkmalskombination der Ansprüche beschränkt.

Die Erfindung wird nun anhand von Abbildungen näher erläutert:
In der Figur 1 ist in stark vereinfachender Weise als Prinzipdarstellung die Erzeugung eines Manchester-kodierten Signals gezeigt.
Figur 2 zeigt ein stark vereinfachtes Blockschaltbild einer erfindungsgemäßen Dekodiereinrichtung zur Erläuterung des erfindungsgemäßen Dekodierungsverfahrens.
Figur 3 zeigt in einer Prinzipskizze die Funktionsweise eines Mittelwertbilders gemäß der Erfindung.
Figur 4 zeigt beispielhaft Signalverläufe zur Erläuterung des erfindungsgemäßen Verfahrens und des Funktionsprinzips der erfindungsgemäßen Dekodiereinrichtung.
Figur 5 zeigt eine weitere erfindungsgemäße Dekodiereinrichtung zur Erläuterung eines vereinfachten erfindungsgemäßen Dekodierungsverfahrens.
Figur 6 zeigt beispielhaft Signalverläufe zur Erläuterung des erfindungsgemäßen Verfahrens und des Funktionsprinzips der erfindungsgemäßen Dekodiereinrichtung nach Figur 5, wobei das empfangene Manchester-kodierte Signal eine Störung aufweist.
Figur 7 zeigt eine weitere erfindungsgemäße Dekodiereinrichtung zur Erläuterung eines vereinfachten erfindungsgemäßen Dekodierungsverfahrens bei welcher ein EOT-Signal zur Rücksetzung der erfindungsgemäßen Dekodiereinrichtung verwendbar ist.

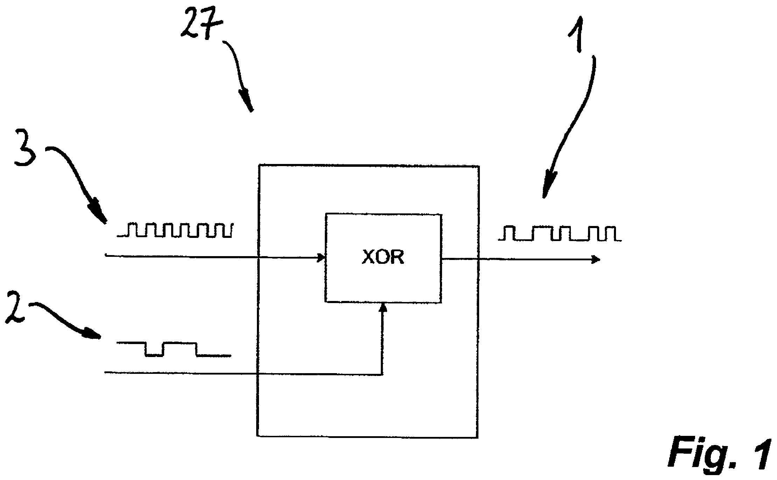

Figur 1 zeigt zur Erläuterung des allgemeinen technologischen Hintergrunds die Erstellung eines Manchester-kodierten Signals 1 mit einer Kodiereinrichtung 27. Dieses Manchester-kodierte Signal 1 entsteht durch XOR-Verknüpfung aus einem ursprünglichen Daten-Signal 2 und einem ursprünglichen Clock-Signal 3 in an sich bekannter Weise.

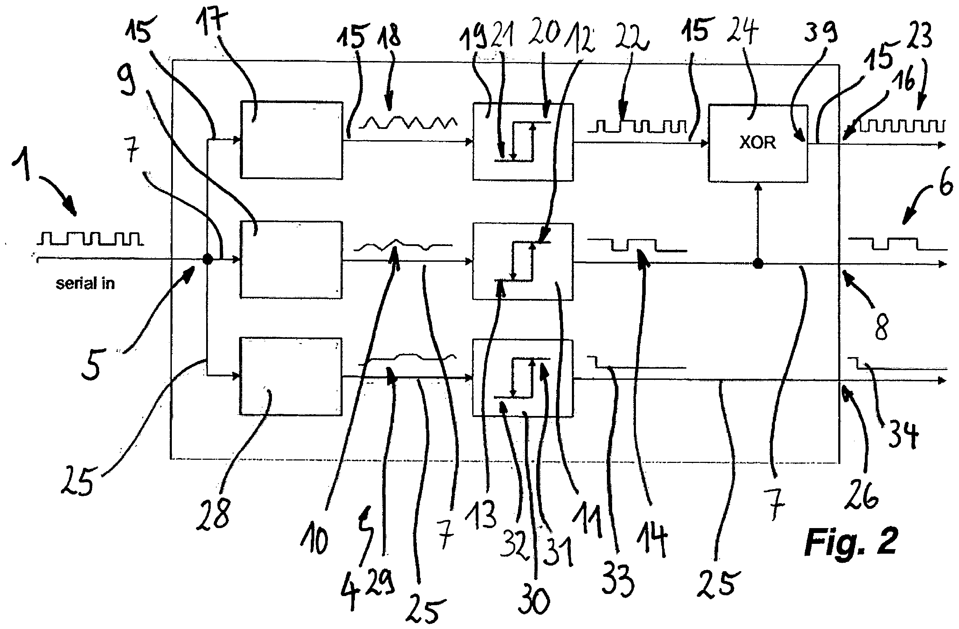

Das Manchester-kodierte Signal 1 wird einem Empfänger zugestellt und von diesem einer in Figur 2 gezeigten, im Ganzen mit 4 bezeichneten Dekodierungseinrichtung zugeführt. Das Manchester-kodierte Signal 1 liegt somit an einem Signaleingang 5 der Dekodierungseinrichtung 4 an.

Die Dekodierungseinrichtung 4 erzeugt aus dem Manchester-kodierten Signal 1 ein dekodiertes Daten-Signal 6, wie im Folgenden näher erläutert wird.

Zur Verarbeitung des Manchester-kodierten Signals 1 ist ein Daten-Signalflussweg 7 ausgebildet, welcher den Signaleingang 5 mit einem Daten-Signalausgang 8 verbindet.

In dem Daten-Signalflussweg 7 ist in Signalflussrichtung zu Beginn ein gleitender Daten-Mittelwertbilder 9 angeordnet, mit welchem aus dem Manchester-kodierten Signal 1 ein gleitender Daten-Mittelwert 10 berechnet wird. Hierbei wird der gleitende Daten-Mittelwert 10 bezüglich einer Daten-Mittelwertzeit gebildet, die gleich der Bitzeit, also der Periode des ursprünglichen Clocks-Signals 3 ist.

In Signalflussrichtung hinter dem gleitenden Daten-Mittelwertbilder 9 ist im Daten-Signalflussweg 7 ein Daten-Komparator 11 angeordnet, welchem der gleitende Daten-Mittelwert 10 zugeführt wird.

In dem Daten-Komparator 11 sind ein unterer Daten-Schwellwert 12 und ein oberer Daten-Schwellwert 13 hinterlegt.

Der Daten-Komparator 11 erzeugt ein Ausgangssignal 14, welches davon abhängt, ob der gleitende Daten-Mittelwert 10 den oberen Daten-Schwellwert 13 überschreitet oder den unteren Daten-Schwellwert 12 unterschreitet. Unterschreitet der gleitende Daten-Mittelwert 10 den unteren Daten-Schwellwert 12, so wird eine logische Null ausgegeben. Überschreitet der gleitende Daten-Mittelwert 10 den oberen Daten-Schwellwert 13, so wird eine logische Eins ausgegeben.

Das Ausgangssignal 14 des Daten-Komparators 11 wird am Daten-Signalausgang 8 als dekodiertes Daten-Signal 6 ausgegeben.

In der Dekodiereinrichtung 4 ist weiter ein Clock-Signalflussweg 15 ausgebildet, welcher den Signaleingang 5 mit einem Clock-Signalausgang 16 verbindet.

In dem Clock-Signalflussweg 15 ist zu Beginn in Signalflussrichtung ein gleitender Clock-Mittelwertbilder 17 angeordnet, mit welchem aus dem Manchester-kodierten Signal 1 ein gleitender Clock-Mittelwert 18 gebildet wird.

Die Funktionsweise des gleitenden Clock-Mittelwertbilders 17 ist analog zu der Funktionsweise des gleitenden Daten-Mittelwertbilders 9, mit dem Unterschied, dass in dem gleitenden Clock-Mittelwertbilder eine Clock-Mittelwertzeit eingestellt ist, die gleich einer halben Bitzeit des ursprünglichen Clock-Signals 3 ist.

Der gleitende Clock-Mittelwert 18 wird einem Clock-Komparator 19 zugeführt.

Der Clock-Komparator 19 funktioniert analog zu dem Daten-Komparator 11, mit dem Unterschied, dass ein abweichender unterer Clock-Schwellwert 20 und ein anderer oberer Clock-Schwellwert 21 festgelegt sind.

Allgemein kann bei diesem Ausführungsbeispiel gesagt werden, dass der untere Daten-Schwellwert 12 gegeben ist durch den Ausdruck 0,25 + D, während der obere Daten-Schwellwert 13 gegeben ist durch den Wert 0,75 - D. Hierbei ist D eine Zahl zwischen -0,25 und +0,25. Es ist ersichtlich, dass das arithmetische Mittel des unteren Daten-Schwellwerts 12 und des oberen Daten-Schwellwerts 13 unabhängig von der Wahl von D bei 0,5 liegt.

Als unterer Clock-Schwellwert 20 ist dagegen bei diesem Ausführungsbeispiel der Wert 0,25 - H festgelegt, während der obere Clock-Schwellwert 21 bei 0,25 + H definiert ist. Hierbei ist H eine Zahl zwischen 0 (inklusive) und +0,25 (exklusive). Es ist ersichtlich, dass das arithmetische Mittel von unterem Clock-Schwellwert 20 und oberem Clock-Schwellwert 21 kleiner ist als das zuvor genannte arithmetische Mittel der Daten-Schwellwerte. Genauer gesagt, liegt dieses arithmetische Mittel der Clock-Schwellwerte im Ausführungsbeispiel bei 0,25.

Bei weiteren erfindungsgemäßen Ausführungsbeispielen müssen die oberen und unteren Schwellwerte nicht notwendig symmetrisch bezüglich eines Mittelwerts verschoben sein. Eine vorteilhafte Wahl ergibt sich für H = 1/12 und/oder D = 1/12. Besonders bevorzugt ist die Wahl H = D= 1/12. Auf diese Weise wird ein relativ guter Kompromiss zwischen der Filterung der Spikes und einer Frequenztoleranz erreicht. Diese Wahl ist bei dem vorliegenden Ausführungsbeispiel und bei dem nachfolgend weiter beschriebenen Ausführungsbeispiel verwirklicht.

Bei weiteren Ausführungsbeispielen sind andere Werte für H und D realisiert. Beispielsweise kann H = 1/12 sein, während D auf einen anderen Wert festgesetzt ist. Es kann auch sein, dass D = 1/12 ist, während H auf einen anderen Wert festgesetzt ist. Schließlich können sowohl H als auch D auf andere Werte festgesetzt sein, als 1/12. Beispielsweise kann generell H = D ≠ 1/12 festgesetzt sein. Es sind für H und/oder D auch Werte im Bereich zwischen 0,06 und 0,1, insbesondere im Bereich zwischen 0,07 und 0,09, mit Vorteil verwendbar.

Aus dem Ausgangssignal 22 des Clock-Komparators 19 wird ein Clock-Signal 23 gebildet und am Clock-Signalausgang 16 bereitgestellt.

Hierzu wird das Ausgangssignal 22 des Clock-Komparators 19 einer Verknüpfungseinrichtung 24 zugeführt.

In der Verknüpfungseinrichtung 24 ist eine logische XOR-Verknüpfung des Ausgangssignals 22 des Clock-Komparators 19 mit dem Ausgangssignal 14 des Daten-Komparators 11, also dem rekonstruierten Daten-Signal 6 realisiert.

Die Verknüpfungseinrichtung 24 ist somit in Signalflussrichtung hinter dem Clock-Komparator 19 im Clock-Signalflussweg 15 angeordnet.

Die Dekodierungseinrichtung 4 weist weiter einen EOT-Signalflussweg 25 auf, der zwischen dem Signaleingang 5 und einem EOT-Signalausgang 26 verläuft.

In dem EOT-Signalflussweg 25 ist in Signalflussrichtung zu Beginn ein gleitender EOT-Mittelwertbilder 28 angeordnet, der analog zu dem gleitenden Daten-Mittelwertbilder 9 und dem gleitenden Clock-Mittelwertbilder 17 arbeitet. Bei dem gleitenden EOT-Mittelwertbilder 28 ist die Mittelwertbildung jedoch bezüglich einer EOT-Mittelwertzeit ausgeführt, welche größer als die Daten-Mittelwertzeit im gleitenden Daten-Mittelwertbilder 9 und als die Clock-Mittelwertzeit im gleitenden Clock-Mittelwertbilder 17 gewählt ist. Im Ausführungsbeispiel ist die EOT-Mittelwertzeit zu 1,5 Bitzeiten des Clock-Signals 3 gewählt.

Der gleitende EOT-Mittelwertbilder 28 erzeugt somit aus dem Manchester-kodierten Signal 1 einen gleitenden EOT-Mittelwert 29, welcher im EOT-Signalflussweg 25 einem EOT-Komparator 30 zugeführt wird.

Der EOT-Komparator 30 arbeitet in analoger Weise wie der Daten-Komparator 11 und der Clock-Komparator 19. An dem EOT-Komparator 30 sind ein unterer EOT-Schwellwert 31 und ein oberer EOT-Schwellwert 32 vorgegeben, welche von den Schwellwerten des Daten-Komparators 11 und des Clock-Komparators 19 abweichen können. Der untere EOT-Schwellwert 31 und der obere EOT-Schwellwert 32 sind so gewählt, dass ein gewünschtes Hystereseverhalten des EOT-Komparators 30 bei der Erzeugung des binären Ausgangssignals 33 erreicht ist.

Besonders günstig ist es, wenn der obere EOT-Schwellwert 32 gleich dem unteren EOT-Schwellwert 31 gewählt ist. Beispielsweise können beiden EOT-Schwellwerte 31, 32 in dem Bereich zwischen 0 und 0,5 festgelegt sein, bevorzugt gleich 0,25.

Dieses Ausgangssignal 33 des EOT-Komparators 30 wird am EOT-Signalausgang 26 als EOT-Signal 34 ausgegeben.

Gegebenenfalls ist im EOT-Signalflussweg 25 hinter dem EOT-Komparator 30 ein nicht weiter dargestellter Invertierer angeordnet.

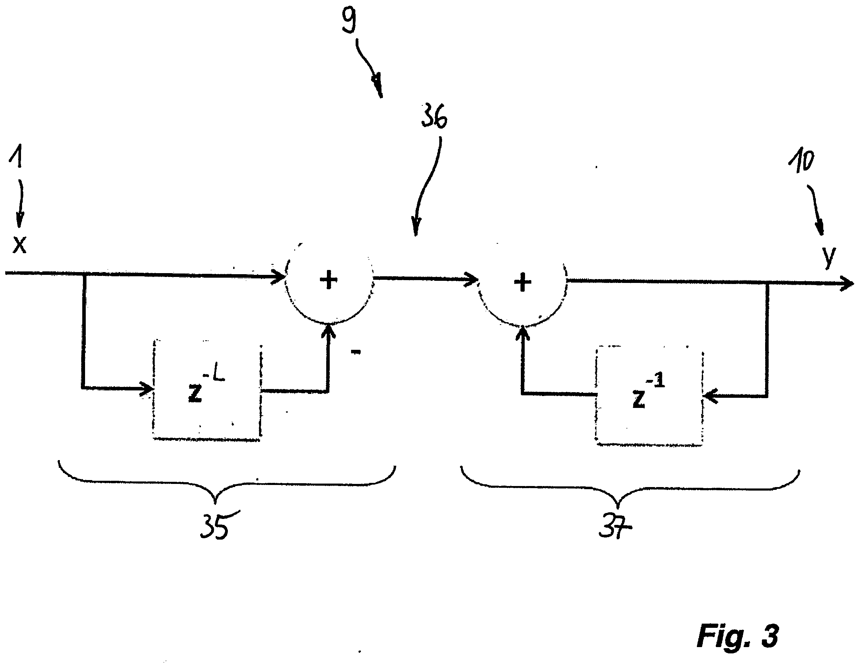

In Figur 3 ist beispielhaft für den Fall des gleitenden Daten-Mittelwertbilders 9 die Funktionsweise der Mittelwertbilder 9, 17, 28 der Dekodierungseinrichtung 4 näher erläutert.

Dem gleitenden Daten-Mittelwertbilder 9 wird das Manchester-kodierte Signal 1 zugeführt.

In einer Differenzstufe 35 wird aus dem Manchester-kodierten Signal 1 ein abgeleitetes Signal 36 in Form eines Differenzsignals abgeleitet. Hierzu wird für die einzelnen Symbole x des Manchester-kodierten Signals 1 jeweils die Differenz des Symbols x zu einem zu diesem Symbol x um eine vorgegebene Zeitdauer L zeitversetzten Symbol in dem Manchester-kodierten Signal 1 gebildet.

Das abgeleitete Signal 36 wird anschließend einer Integrationsstufe 37 zugeführt, in welcher das abgeleitete Signal 36 aufintegriert wird. Der gleitende Daten-Mittelwertbilder 9 stellt somit einen gleitenden Daten-Mittelwert 10 bereit, welcher aus Symbolen y zusammengesetzt ist.

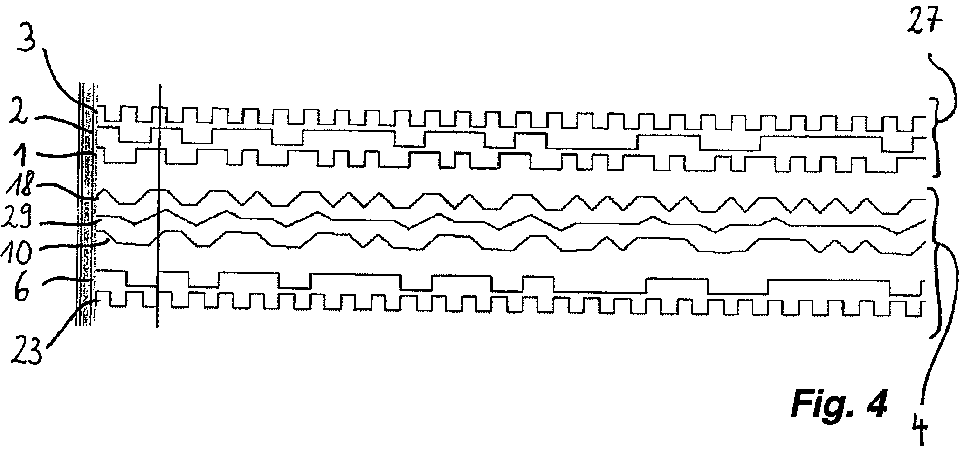

Figur 4 zeigt beispielhaft einen Signalverlauf an der Kodiereinrichtung 27 und der Dekodierungseinrichtung 4.

In der Kodiereinrichtung 27 wird zu dem eingegebenen ursprünglichen Daten-Signal 2 und einem in der Kodiereinrichtung 27 erzeugten ursprünglichen Clock-Signal 3 ein Manchester-kodiertes Signal 1 erzeugt.

Dieses Manchester-kodierte Signal 1 wird an die Dekodierungseinrichtung 4 übertragen.

In der Dekodierungseinrichtung 4 werden - wie beschrieben - ein gleitender Daten-Mittelwert 10, ein gleitender Clock-Mittelwert 18 und ein gleitender EOT-Mittelwert 29 aus dem Manchester-kodierten Signal 1 gebildet.

Es ist ersichtlich, dass diese Mittelwerte nicht binär sind, sondern sehr feingestuft, nahezu analog.

Mit den erwähnten Komparatoren wird aus dem gleitenden Daten-Mittelwert 10 das dekodierte Daten-Signal 6 erzeugt. Mit diesem Daten-Signal 6 und dem gleitenden Clock-Mittelwert 18 wird durch den beschriebenen Schwellwertvergleich im Clock-Komparator 19 und durch die ebenfalls beschriebene logische Verknüpfung in der Verknüpfungseinrichtung 24 ein Clock-Signal 23 erzeugt und ausgegeben. Es ist ersichtlich, dass das Clock-Signal 23 dieselbe Bitzeit wie das ursprüngliche Clock-Signal 3 aufweist, dass aber die dekodierten Signale 6, 23 gegenüber den ursprünglichen Signalen 2, 3 zeitversetzt sind.

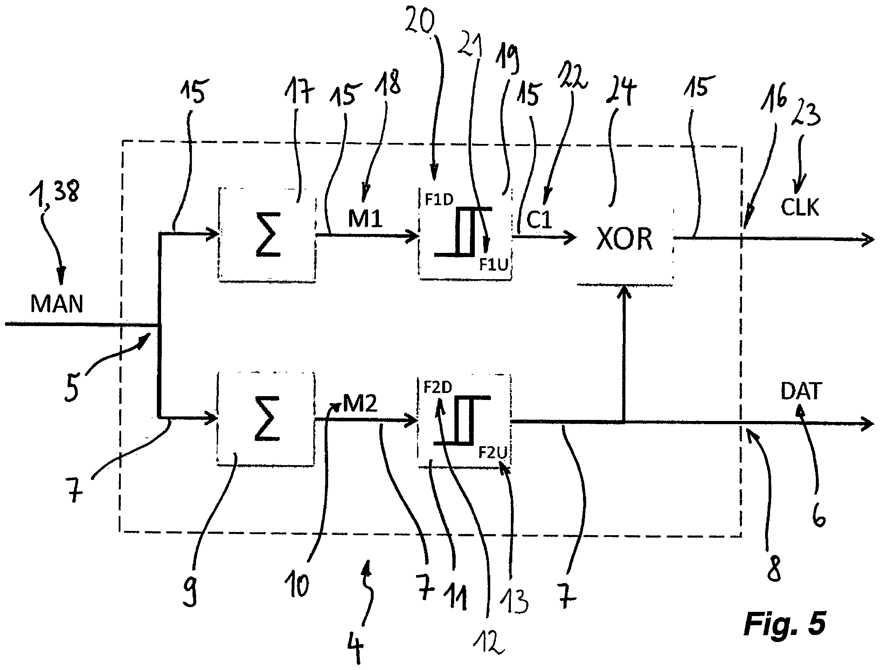

Figur 5 zeigt ein weiteres erfindungsgemäßes Ausführungsbeispiel einer Dekodierungseinrichtung 4.

Bei der Dekodierungseinrichtung 4 gemäß Figur 5 sind funktionell und/oder konstruktiv zu der Dekodierungseinrichtung gemäß Figur 2 gleiche oder ähnliche Bauteile mit demselben Bezugszeichen bezeichnet und nicht noch einmal gesondert beschrieben. Die dort erläuterten Ausführungen gelten für die Dekodierungseinrichtung 4 gemäß Figur 5 entsprechend.

Im Unterschied zu dem Ausführungsbeispiel gemäß Figur 2 ist bei der Dekodierungseinrichtung 4 gemäß Figur 5 kein EOT-Signalflussweg ausgebildet.

Vielmehr weist die Dekodierungseinrichtung 4 nur einen Daten-Signalflussweg 7 und einen Clock-Signalflussweg 15 auf, die in der zu Figur 2 und Figur 3 beschriebenen Weise arbeiten.

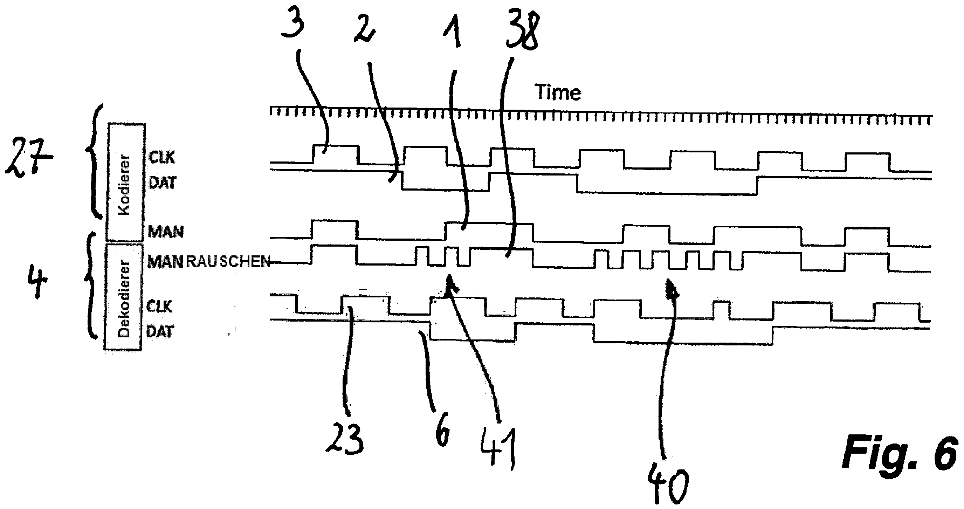

Figur 6 zeigt einen typischen Signalverlauf beispielhaft für die Dekodierungseinrichtung 4 gemäß Figur 5.

Wie bereits zu Figur 4 erläutert, wird in der Kodiereinrichtung 27 ein Manchester-kodiertes Signal 1 aus einem ursprünglichen Daten-Signal 2 und einem ursprünglichen Clock-Signal 3 erzeugt.

Dieses Manchester-kodierte Signal 1 wird an die Dekodierungseinrichtung 4 übertragen.

Zur Erläuterung der Robustheit des erfindungsgemäßen Verfahrens sei angenommen, dass bei der Übertagung das Manchester-kodierte Signal 1 durch Rauschen mit höherfrequenten Störungen 40, 41 gestört ist.

An der Dekodierungseinrichtung 4 wird daher ein gestörtes Manchester-kodiertes Signal 38 empfangen.

Aus dem gestörten Manchester-kodierten Signal 38 bildet die Dekodierungseinrichtung 4 in analoger Weise zu den Erläuterungen zu Figur 1 bis 4 ein dekodiertes Daten-Signal 6 und ein dekodiertes Clock-Signal 23.

Es ist ersichtlich, dass die Störungen 40 und 41 eine temporär fehlerhafte Bit-Zeit des Clock-Signals 23 bewirken, die jedoch sehr schnell wieder auf die tatsächliche Bitzeit des ursprünglichen Clock-Signals 3 zurückkehrt.

Es ist weiter ersichtlich, dass das Clock-Signal 23 synchron mit dem Daten-Signal 6 umschaltet, so dass auch bei temporär geringfügig fehlerhaften Bitzeiten des Clock-Signals 23 das Daten-Signal 6 richtig interpretierbar ist.

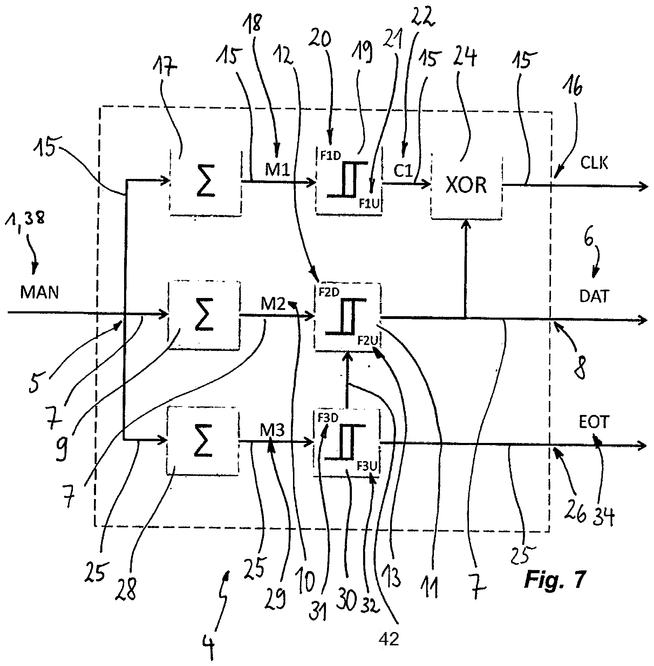

Figur 7 zeigt ein weiteres erfindungsgemäßes Ausführungsbeispiel einer Dekodierungseinrichtung 4.

Bei der Dekodierungseinrichtung 4 gemäß Figur 7 sind funktionell und/oder konstruktiv zu der Dekodierungseinrichtung gemäß Figur 2 und/oder 5 gleiche oder ähnliche Bauteile mit demselben Bezugszeichen bezeichnet und nicht noch einmal gesondert beschrieben. Die dort erläuterten Ausführungen gelten für die Dekodierungseinrichtung 4 gemäß Figur 7 entsprechend.

Bei der Dekodiereinrichtung 4 ist zusätzlich zu dem Ausführungsbeispiel nach Figur 2 eine Steuerverbindung 42 zwischen dem EOT-Komparator 30 und dem Daten-Komparator 11 ausgebildet. Die Dekodiereinrichtung 4 ist so eingerichtet, dass die Daten-Schwellwerte 12, 13 im Daten-Komparator 11 auf Standardwerte zurücksetzbar sind oder zurückgesetzt werden, wenn in dem EOT-Komparator 30 ein Übertragungsende detektiert ist oder wird. Somit ist die Empfindlichkeit des Daten-Komparators 11 nach der vollständigen DatenÜbertragung zurücksetzbar und wird zurückgesetzt, um die Dekodiereinrichtung 4 zum erneuten Datenempfang vorzubereiten.

Bei weiteren Ausführungsbeispielen ist alternativ oder zusätzlich eine Steuerverbindung zwischen dem EOT-Komparator 30 und dem gleitenden Daten-Mittelwertbilder 9 ausgebildet. Bei diesen Ausführungsbeispielen kann somit die Mittelwertbildung bei erneuter Datenübertragung von einem definierten Startwert aus erfolgen. Es ist so beispielsweise die Dekodierung des Eingangssignals vom Signaleingang 5 sperrbar und gesperrt, solange der EOT-Komparator 30 noch keine Signalübertragung erkannt hat. Logische Sequenzen zur Markierung des Signalanfangs sind verzichtbar.

Es sei zu Figur 3 noch erwähnt, dass die Zeitdauer L in der Differenzstufe 35 die jeweilige Mittelwertzeit des gleitenden Daten-Mittelwertbilders 9, des gleitenden Clock-Mittelwertbilders 17 und des gleitenden EOT-Mittelwertbilders 28 definieren.

Aus den Figuren 4 und 6 ist ersichtlich, dass die gleitenden Mittelwerte 10, 18, 29 gleichzeitig und zeitlich parallel zueinander fortlaufend gebildet werden, während zeitgleich weitere Symbole x des Manchester-kodierten Signals 1 am Signaleingang 5 bereitgestellt werden. Die Bildung des Daten-Signals 6 und des Clock-Signals 23 und gegebenenfalls des EOT-Signals 34 erfolgen daher in Echtzeit synchron mit dem Takt des Manchester-kodierten Signals 1.

Der Arbeitstakt der Dekodierungseinrichtung 4 ist durch eine Sampling-Rate vorgegeben, mit welcher die erwähnten Mittelwerte 10, 18, 29 in den Mittelwertbildern 9, 17, 28 erzeugt werden. Bei dem vorgestellten Ausführungsbeispiel wird eine Sampling-Rate verwendet welche 256 Abtastungen je Bitzeit des Clock-Signals 3 aufnimmt. Bei weiteren Ausführungsbeispielen sind andere Sampling-Raten realisiert.

Es sei noch erwähnt, dass die hier beschriebenen Verfahren auch auf invertiert gesendete Eingangssignale übertragbar sind. In einem solchen Fall muss die a priori bekannte Startfolge des Manchester-kodierten Signals 1 angepasst werden. Ebenso kann die Anwendung auf die Übertragung mit einem Idle-Zustand 1 übertragen werden.

Bei der Dekodiereinrichtung 4 für ein Manchester-kodiertes Signal 1 wird vorgeschlagen, mit gleitenden Mittelwertbildern 9, 17, 28 wenigstens einen gleitenden Daten-Mittelwert 10 und/oder einen gleitenden Clock-Mittelwert 18 bezüglich zueinander verschiedener Mittelwertzeiten zu bilden und aus diesen gleitenden Mittelwerten 10, 18, 29 mittels Komparatoren 11, 19, 30 binäre Ausgangssignale als Daten-Signal 6 und/oder Clock-Signal 23 bereitzustellen.

### Bezugszeichenliste

- 1: Manchester-kodiertes Signal
- 2: ursprüngliches Daten-Signal
- 3: ursprüngliches Clock-Signal
- 4: Dekodierungseinrichtung
- 5: Signaleingang
- 6: Daten-Signal
- 7: Daten-Signalflussweg
- 8: Daten-Signalausgang
- 9: gleitender Daten-Mittelwertbilder
- 10: gleitender Daten-Mittelwert
- 11: Daten-Komparator
- 12: unterer Daten-Schwellwert
- 13: oberer Daten-Schwellwert
- 14: Ausgangssignal
- 15: Clock-Signalflussweg
- 16: Clock-Signalausgang
- 17: gleitender Clock-Mittelwertbilder
- 18: gleitender Clock-Mittelwert
- 19: Clock-Komparator
- 20: unterer Clock-Schwellwert
- 21: oberer Clock-Schwellwert
- 22: Ausgangssignal
- 23: Clock-Signal
- 24: Verknüpfungseinrichtung
- 25: EOT-Signalflussweg
- 26: EOT-Signalausgang
- 27: Kodiereinrichtung
- 28: gleitender EOT-Mittelwertbilder
- 29: gleitender EOT-Mittelwert
- 30: EOT-Komparator
- 31: unterer EOT-Schwellwert
- 32: oberer EOT-Schwellwert
- 33: Ausgangssignal
- 34: EOT-Signal
- 35: Differenzstufe
- 36: abgeleitetes Signal
- 37: Integrationsstufe
- 38: gestörtes Machester-kodiertes Signal
- 39: Signalausgang
- 40: Störung
- 41: Störung
- 42: Steuerverbindung
- x: Symbol
- y: Symbol
- L: Zeitdauer

## Patentansprüche

1. Dekodierungsverfahren für ein Manchester-kodiertes Signal (1),
wobei,
- für das Manchester-kodierte Signal (1) ein gleitender Daten-Mittelwert (10) mit einer Daten-Mittelwertzeit gebildet wird,
- wobei aus dem gleitenden Daten-Mittelwert (10) mit einem Daten-Komparator (11) ein dekodiertes Daten-Signal (6) gebildet und bereitgestellt wird,
- wobei für das Manchester-kodierte Signal (1) ein gleitender Clock-Mittelwert (18) mit einer Clock-Mittelwertzeit gebildet wird,
- wobei zumindest aus dem gleitenden Clock-Mittelwert (18) mit einem Clock-Komparator (19) ein Clock-Signal (23) gebildet und bereitgestellt wird,
**dadurch gekennzeichnet, dass**
zur Bildung des Clock-Signals (23) ein Ausgangssignal (22) des Clock-Komparators (19) mit einem Ausgangssignal (14) des Daten-Komparators (11) logisch verknüpft wird.

2. Dekodierungsverfahren nach Anspruch 1,
**dadurch gekennzeichnet,**
**dass** die Clock-Mittelwertzeit kürzer als die Daten-Mittelwertzeit ist
und/oder dass
zur Bildung des/der gleitenden Daten- (10) und/oder Clock-Mittelwert (18) ein aus dem Manchester-kodierten Signal (1) abgeleitetes Signal (36) über die Daten- und/oder Clock-Mittelwertzeit integriert wird.

3. Dekodierungsverfahren nach einem der vorangegangenen Ansprüche,
**dadurch gekennzeichnet,**
**dass** zur Bildung des gleitenden Daten- (10) und/oder Clock-Mittelwerts (18) fortschreitend ein Differenzsignal von Differenzen zwischen jedem Symbol (x) des Manchester-kodierten Signals und einem zu diesem Symbol (x) um eine vorgegebene Zeitdauer (L) zeitversetzten Symbol des Manchester-kodierten Signals (1) als das aus dem Manchester-kodierten Signal (1) abgeleitete Signal (36) gebildet wird.

4. Dekodierungsverfahren nach einem der vorangegangenen Ansprüche,
**dadurch gekennzeichnet,**
**dass** der Daten-Komparator (11) den gleitenden Daten-Mittelwert (10) mit wenigstens einem Daten-Schwellwert (12, 13) vergleicht und das dekodierte Daten-Signal (6) in Abhängigkeit von einem Überschreiten oder Unterschreiten des wenigstens einen Daten-Schwellwerts (12, 13) ausgibt.

5. Dekodierungsverfahren nach dem vorangegangenen Anspruch,
**dadurch gekennzeichnet,**
**dass** der wenigstens eine Daten-Schwellwert (12, 13) einen unteren Daten-Schwellwert (12) und einen oberen Daten-Schwellwert (13) umfasst und dass der Daten-Komparator (11) das dekodierte Daten-Signal (6) in Abhängigkeit von einem Überschreiten des oberen Daten-Schwellwerts (13) und/oder einem Unterschreiten des unteren Daten-Schwellwerts (12) ausgibt.

6. Dekodierungsverfahren nach dem vorangegangenen Anspruch,
**dadurch gekennzeichnet,**
**dass** ein arithmetischer Mittelwert des unteren Daten-Schwellwerts (12) und des oberen Daten-Schwellwerts (13) zwischen Null und Eins, insbesondere bei 1/2, liegt
und/oder
**dass** als Daten-Mittelwertzeit eine Zeitdauer, die größer als eine halbe Bitzeit und/oder kleiner als das 1,5fache der Bitzeit, insbesondere gleich der Bitzeit, eines Clock-Signals (3) des Manchester-kodierten Signals (1) ist, eingerichtet wird.

7. Dekodierungsverfahren nach einem der vorangegangenen Ansprüche,
**dadurch gekennzeichnet,**
**dass** als Clock-Mittelwertzeit eine Zeitdauer, die kleiner als eine Bitzeit, insbesondere gleich der halben Bitzeit, eines Clock-Signals (3) des Manchester-kodierten Signals (1) ist, eingerichtet wird.

8. Dekodierungsverfahren nach einem der vorangegangenen Ansprüche,
**dadurch gekennzeichnet,**
**dass** der Clock-Komparator (19) den gleitenden Clock-Mittelwert (18) mit wenigstens einem Clock-Schwellwert (20, 21) vergleicht und ein Ausgangssignal (22) in Abhängigkeit von einem Überschreiten oder Unter-schreiten des wenigstens einen Clock-Schwellwerts (20, 21) ausgibt.

9. Dekodierungsverfahren nach einem der vorangegangenen Ansprüche,
**dadurch gekennzeichnet,**
**dass** der wenigstens eine Clock-Schwellwert (20, 21) einen unteren Clock-Schwellwert (20) und einen oberen Clock-Schwellwert (21) umfasst und dass der Clock-Komparator (19) ein Ausgangssignal (22) in Abhängigkeit von einem Überschreiten des oberen Clock-Schwellwerts (21) und/oder einem Unterschreiten des unteren Clock-Schwellwerts (20) ausgibt.

10. Dekodierungsverfahren nach dem vorangegangenen Anspruch,
**dadurch gekennzeichnet,**
**dass** ein arithmetischer Mittelwert des unteren Clock-Schwellwerts (20) und des oberen Clock-Schwellwerts (21) zwischen Null und Eins, insbesondere unterhalb des arithmetischen Mittelwerts (20) von unterem Daten-Schwellwert (12) und oberem Daten-Schwellwerts (8) und/oder bei 1/4, liegt und/oder dass der gleitende Daten- (10) und/oder Clock-Mittelwert (18) gleichzeitig und/oder zeitlich parallel zueinander gebildet wird/werden.

11. Dekodierungsverfahren nach einem der vorangegangenen Ansprüche,
**dadurch gekennzeichnet, dass**
der gleitende Daten- (10) und/oder Clock-Mittelwert (18) mit einer Sampling-Rate gebildet wird/werden, die jeweils kleiner als die oder eine Bitzeit, insbesondere kleiner als ein Zehntel oder ein Hundertstel, des Clock-Signals (3) des Manchester-kodierten Signals (1) ist,
und/oder dass
der gleitende Daten- (10) und/oder Clock-Mittelwert (18) zeitgleich zu einer Bereitstellung weiterer Symbole (x) des Manchester-kodierten Signals (1) gebildet wird/werden.

12. Dekodiereinrichtung (4),
mit einem Signaleingang (5) für ein Manchester-kodiertes Signal (1),
einem Daten-Signalausgang (8) für ein aus dem Manchester-kodierten Signal (1) dekodiertes Daten-Signal (6)
und einem Clock-Signalausgang (16) für ein aus dem Manchester-kodierten Signal (1) dekodiertes Clock-Signal (23),
wobei
ein Daten-Signalflussweg (7) vom Signaleingang (5) zu einem gleitenden Daten-Mittelwertbilder (9),
von diesem zu einem Daten-Komparator (11)
und von diesem zu dem Daten-Signalausgang (8) eingerichtet ist,
ein Clock-Signalflussweg (15) vom Signaleingang (5) zu einem gleitenden Clock-Mittelwertbilder (17),
von diesem zu einem Clock-Komparator (19)
und von diesem zu dem Clock-Signalausgang (16) eingerichtet ist,
**dadurch gekennzeichnet, dass**
zur Bildung des Clock-Signals (23) eine Verknüpfungseinrichtung (24) zur logischen Verknüpfung eines Ausgangssignals (14) des Daten-Komparators (11) mit einem Ausgangssignal (22) des Clock-Komparators (19) eingerichtet ist.

13. Dekodiereinrichtung (4) nach Anspruch 12,
**dadurch gekennzeichnet,**
**dass** mit dem gleitenden Daten-Mittelwertbilder (9) ein gleitender Mittelwert eines aus dem Manchester-kodierten Signal (1) abgeleiteten Signals (36) über eine Daten-Mittelwertzeit bildbar ist.

14. Dekodiereinrichtung (4) nach einem der Ansprüche 12 oder 13,
**dadurch gekennzeichnet,**
**dass** mit dem gleitenden Clock-Mittelwertbilder (17) ein gleitender Mittelwert eines aus dem Manchester-kodierten Signal (1) abgeleiteten Signals (36) über eine Clock-Mittelwertzeit bildbar ist.

15. Dekodiereinrichtung (4) nach einem der Ansprüche 12 bis 14,
**dadurch gekennzeichnet,**
**dass** der Clock-Signalflussweg (15) von einem Signalausgang (39) der Verknüpfungseinrichtung (24) zu dem Clock-Signalausgang (16) geführt ist.

16. Dekodiereinrichtung (4) nach einem der Ansprüche 12 bis 15,
**dadurch gekennzeichnet,**
**dass** der Daten-Komparator (11) zur Ausgabe eines Ausgangssignals (14) in Abhängigkeit von einem Überschreiten oder Unterschreiten wenigstens eines Daten-Schwellwerts (12, 13), insbesondere zur Ausgabe eines Ausgangssignals (14) in Abhängigkeit von einem Überschreiten eines oberen Daten-Schwellwerts (13) des wenigstens einen Daten-Schwellwertes (12, 13)
und/oder
einem Unterschreiten eines unteren Daten-Schwellwerts (12) des wenigstens einen Daten-Schwellwertes (12, 13),
eingerichtet ist.

17. Dekodiereinrichtung (4) nach einem der Ansprüche 12 bis 16,
**dadurch gekennzeichnet,**
**dass** der Clock-Komparator (19) zur Ausgabe eines Ausgangssignals (22) in Abhängigkeit von einem Überschreiten oder Unterschreiten wenigstens eines Clock-Schwellwerts (20, 21), insbesondere zur Ausgabe eines Ausgangssignals (22) in Abhängigkeit von einem Überschreiten eines oberen Clock-Schwellwerts (21) des wenigstens einen Clock-Schwellwertes (20, 21)
und/oder
einem Unterschreiten eines unteren Clock-Schwellwerts (20) des wenigstens einen Clock-Schwellwerts (20, 21),
eingerichtet ist.

18. Dekodiereinrichtung (4) nach einem der Ansprüche 12 bis 17,
**dadurch gekennzeichnet, dass**
sie zur gleichzeitigen und/oder zeitlich parallelen Bildung der gleitenden Daten- (10) und/oder Clock-Mittelwerte (18) eingerichtet ist,
insbesondere wobei der gleitende Daten- (10) und/oder Clock-Mittelwert (18) mit einer Sampling-Rate bildbar ist/sind, die jeweils kleiner als die oder eine Bitzeit, insbesondere kleiner als ein Zehntel oder ein Hundertstel, des oder eines Clock-Signals (3) des Manchester-kodierten Signals (1) ist,
und/oder dass
sie zur zeitgleichen Bildung des gleitenden Daten- (10) und/oder Clock-Mittelwerts (18) mit der Bereitstellung weiterer Symbole des Manchester-kodierten Signals (1) eingerichtet ist.

## Claims

1. Decoding method for a Manchester-encoded signal (1),
wherein
- a moving data average (10) having a data average time is formed for the Manchester-encoded signal (1),
- wherein a decoded data signal (6) is formed from the moving data average (10) using a data comparator (10) and is made available,
- wherein a moving clock average (18) having a clock average time is formed for the Manchester-encoded signal (1),
- wherein a clock signal (23) is formed at least from the moving clock average (18) using a clock comparator (19) and is made available,
**characterised in that**
to form the clock signal (23), an output signal (22) of the clock comparator (19) is logically linked to an output signal (14) of the data comparator (11).

2. Decoding method according to claim 1,
**characterised in that**
the clock average time is shorter than the data average time
and/or **in that**
to form the moving data average (10) and/or moving clock average (18), a signal (36) derived from the Manchester-encoded signal (1) is integrated over the data average time and/or clock average time.

3. Decoding method according to any of the preceding claims,
**characterised in that**
to form the moving data average (10) and/or moving clock average (18), a difference signal of differences between each symbol (x) of the Manchester-encoded signal and a symbol of the Manchester-encoded signal (1) that is time-shifted relative to said symbol (x) by a predefined time period (L) is continually formed as the signal (36) derived from the Manchester-encoded signal (1).

4. Decoding method according to any of the preceding claims,
**characterised in that**
the data comparator (11) compares the moving data average (10) with at least one data threshold (12, 13) and outputs the decoded data signal (6) depending on whether the result exceeds or falls below the at least one data threshold (12, 13).

5. Decoding method according to the preceding claim,
**characterised in that**
the at least one data threshold (12, 13) includes a lower data threshold (12) and an upper data threshold (13) and **in that** the data comparator (11) outputs the decoded data signal (6) depending on whether the result exceeds the upper data threshold (13) and/or falls below the lower data threshold (12).

6. Decoding method according to the preceding claim,
**characterised in that**
an arithmetic average of the lower data threshold (12) and the upper data threshold (13) is between zero and one, in particular is 1/2,
and/or
**in that** a time period that is greater than half a bit time and/or smaller than 1.5 times the bit time, in particular is the same as the bit time, of a clock signal (3) of the Manchester-encoded signal (1) is configured as the data average time.

7. Decoding method according to any of the preceding claims,
**characterised in that**
a time period that is smaller than a bit time, in particular is equal to half the bit time, of a clock signal (3) of the Manchester-encoded signal (1) is configured as the clock average time.

8. Decoding method according to any of the preceding claims,
**characterised in that**
the clock comparator (19) compares the moving clock average (18) with at least one clock threshold (20, 21) and outputs an output signal (22) depending on whether the result exceeds or falls below the at least one clock threshold (20, 21).

9. Decoding method according to any of the preceding claims,
**characterised in that**
the at least one clock threshold (20, 21) includes a lower clock threshold (20) and an upper clock threshold (21) and **in that** the clock comparator (19) outputs an output signal (22) depending on whether the result exceeds the upper clock threshold (21) and/or falls below the lower clock threshold (20).

10. Decoding method according to the preceding claim,
**characterised in that**
an arithmetic average of the lower clock threshold (20) and the upper clock threshold (21) is between zero and one, in particular is below the arithmetic average (20) of the lower data threshold (12) and the upper data threshold (8) and/or is 1/4, and/or **in that** the moving data average (10) and/or moving clock average (18) is/are formed simultaneously and/or concurrently with one another.

11. Decoding method according to any of the preceding claims,
**characterised in that**
the moving data average (10) and/or moving clock average (18) is/are formed at sampling rates that are less than the or a bit time, in particular less than one tenth or one hundredth, of the clock signal (3) of the Manchester-encoded signal (1),
and/or **in that**
the moving data average (10) and/or moving clock average (18) is/are formed simultaneously with additional symbols (x) of the Manchester-encoded signal (1) being made available.

12. Decoding device (4),
comprising a signal input (5) for a Manchester-encoded signal (1),
a data signal output (8) for a data signal (6) decoded from the Manchester-encoded signal (1),
and a clock signal output (16) for a clock signal (23) decoded from the Manchester-encoded signal (1),
wherein
a data signal flow path (7) is configured from the signal input (5) to a moving-type data averaging unit (9),
from there to a data comparator (11)
and from there to the data signal output (8),
a clock signal flow path (15) is configured from the signal input (5) to a moving-type clock averaging unit (17),
from there to a clock comparator (19)
and from there to the clock signal output (16),
**characterised in that**
to form the clock signal (23), a linking device (24) is designed to logically link an output signal (14) of the data comparator (11) to an output signal (22) of the clock comparator (19).

13. Decoding device (4) according to claim 12,
**characterised in that**
by means of the moving-type data averaging unit (9), a moving average of a signal (36) derived from the Manchester-encoded signal (1) can be formed over a data average time.

14. Decoding device (4) according to any of claims 12 or 13,
**characterised in that**
by means of the moving-type clock averaging unit (17), a moving average of a signal (36) derived from the Manchester-encoded signal (1) can be formed over a clock average time.

15. Decoding device (4) according to any of claims 12 to 14,
**characterised in that**
the clock signal flow path (15) is guided from a signal output (39) of the linking device (24) to the clock signal output (16).

16. Decoding device (4) according to any of claims 12 to 15,
**characterised in that**
the data comparator (11) is designed to output an output signal (14) depending on whether a result exceeds or falls below at least one data threshold (12, 13), in particular to output an output signal (14) depending on whether a result exceeds an upper data threshold (13) of the at least one data threshold (12, 13)
and/or
falls below a lower data threshold (12) of the at least one data threshold (12, 13).

17. Decoding device (4) according to any of claims 12 to 16,
**characterised in that**
the clock comparator (19) is designed to output an output signal (22) depending on whether a result exceeds or falls below at least one clock threshold (20, 21), in particular to output an output signal (22) depending on whether a result exceeds an upper clock threshold (21) of the at least one clock threshold (20, 21)
and/or
falls below a lower clock threshold (20) of the at least one clock threshold (20, 21).

18. Decoding device (4) according to any of claims 12 to 17,
**characterised in that**
said device is designed to simultaneously and/or concurrently form the moving data average (10) and/or moving clock average (18),
in particular wherein the moving data average (10) and/or moving clock average (18) can be formed at sampling rates that are less than the or a bit time, in particular less than one tenth or one hundredth, of the or a clock signal (3) of the Manchester-encoded signal (1),
and/or **in that**
said device is designed to form the moving data average (10) and/or moving clock average (18) simultaneously with additional symbols of the Manchester-encoded signal (1) being made available.

## Revendications

1. Procédé de décodage pour un signal codé Manchester (1),
dans lequel,
- pour le signal codé Manchester (1), une moyenne de données mobile (10) avec un temps moyen de données est formée,
- un signal de données décodé (6) est formé à partir de la moyenne de données mobile (10) avec un comparateur de données (11) et mis à disposition,
- un moyenne d'horloge mobile (18) avec un temps moyen d'horloge est formée pour le signal codé Manchester (1),
- un signal d'horloge (23) est formé au moins à partir de la moyenne d'horloge mobile (18) avec un comparateur d'horloge (19) et mis à disposition,
**caractérisé en ce que**
pour former le signal d'horloge (23), un signal de sortie (22) du comparateur d'horloge (19) est combiné logiquement avec un signal de sortie (14) du comparateur de données (11).

2. Procédé de décodage selon la revendication 1,
**caractérisé en ce**
**que** le temps moyen d'horloge est plus court que le temps moyen de données et/ou
**que** pour former la moyenne de données mobile (10) et/ou la moyenne d'horloge mobile (18), un signal (36) dérivé du signal codé Manchester (1) est intégré sur le temps moyen de données et/ou d'horloge.

3. Procédé de décodage selon l'une des revendications précédentes,
**caractérisé en ce**
**que**, pour former la moyenne de données mobile (10) et/ou la moyenne d'horloge mobile (18), un signal différentiel de différences entre chaque symbole (x) du signal codé Manchester et un symbole du signal codé Manchester (1) qui est décalé d'une durée prédéterminée (L) par rapport à ce symbole (x) est formé progressivement en tant que signal (36) dérivé du signal codé Manchester (1).

4. Procédé de décodage selon l'une des revendications précédentes,
**caractérisé en ce**
**que** le comparateur de données (11) compare la moyenne de données mobile (10) avec au moins une valeur seuil de données (12, 13) et délivre le signal de données décodé (6) en fonction d'un dépassement ou d'un passage sous ladite au moins une valeur seuil de données (12, 13).

5. Procédé de décodage selon la revendication précédente,
**caractérisé en ce**
**que** ladite au moins une valeur seuil de données (12, 13) comprend une valeur seuil de données inférieure (12) et une valeur seuil de données supérieure (13), et que le comparateur de données (11) délivre le signal de données décodé (6) en fonction d'un dépassement vers le haut de la valeur seuil de données supérieure (13) et/ou d'un passage sous la valeur seuil de données inférieure (12).

6. Procédé de décodage selon la revendication précédente,
**caractérisé en ce**
**qu'**une moyenne arithmétique de la valeur seuil de données inférieure (12) et de la valeur seuil de données supérieure (13) se situe entre zéro et un, en particulier à 1/2, et/ou
**qu'**une durée qui est supérieure à un demi-temps de bit et/ou inférieure à 1,5 fois le temps de bit, en particulier égale au temps de bit, d'un signal horloge (3) du signal codé Manchester (1) est définie comme temps moyen de données.

7. Procédé de décodage selon l'une des revendications précédentes,
**caractérisé en ce**
**qu'**une durée qui est inférieure à un temps de bit, en particulier égale au demi-temps de bit, d'un signal d'horloge (3) du signal codé Manchester (1) est définie comme temps moyen d'horloge.

8. Procédé de décodage selon l'une des revendications précédentes,
**caractérisé en ce**
**que** le comparateur d'horloge (19) compare la moyenne d'horloge mobile (18) avec au moins une valeur seuil d'horloge (20, 21) et délivre un signal de sortie (22) en fonction d'un dépassement ou d'un passage sous ladite au moins une valeur seuil d'horloge (20, 21).

9. Procédé de décodage selon l'une des revendications précédentes,
**caractérisé en ce**
**que** ladite au moins une valeur seuil d'horloge (20, 21) comprend une valeur seuil d'horloge inférieure (20) et une valeur seuil d'horloge supérieure (21), et que le comparateur d'horloge (19) délivre un signal de sortie (22) en fonction d'un dépassement de la valeur seuil d'horloge supérieure (21) et/ou d'un passage sous la valeur seuil d'horloge inférieure (20).

10. Procédé de décodage selon la revendication précédente,
**caractérisé en ce**
**qu'**une moyenne arithmétique de la valeur seuil d'horloge inférieure (20) et de la valeur seuil d'horloge supérieure (21) se situe entre zéro et un, en particulier au-dessous de la moyenne arithmétique (20) de la valeur seuil de données inférieure (12) et de la valeur seuil de données supérieure (8) et/ou à 1/4, et/ou que la moyenne de données mobile (10) et/ou la moyenne d'horloge mobile (18) est/sont formée(s) simultanément et/ou parallèlement l'une à l'autre dans le temps.

11. Procédé de décodage selon l'une des revendications précédentes,
**caractérisé en ce**
**que** la moyenne de données mobile (10) et/ou la moyenne d'horloge mobile (18) est/sont formée(s) à une fréquence d'échantillonnage qui est chaque fois inférieure au ou à un temps de bit, en particulier inférieure à un dixième ou un centième, du signal d'horloge (3) du signal codé Manchester (1),
et/ou
**que** la moyenne de données mobile (10) et/ou la moyenne d'horloge mobile (18) est/sont formée(s) simultanément à une mise à disposition d'autres symboles (x) du signal codé Manchester (1).

12. Dispositif de décodage (4),
comportant une entrée de signal (5) pour un signal codé Manchester (1),
une sortie de signal de données (8) pour un signal de données (6) décodé à partir du signal codé Manchester (1)
et une sortie de signal d'horloge (16) pour un signal d'horloge (23) décodé à partir du signal codé Manchester (1),
dans lequel
un chemin de flux de signal de données (7) est configuré de l'entrée de signal (5) vers un formateur de moyenne de données mobile (9),
de ce dernier vers un comparateur de données (11)
et de ce dernier vers la sortie de signal de données (8),
un chemin de flux de signal d'horloge (15) est configuré de l'entrée de signal (5) vers un formateur de moyenne d'horloge mobile (17),
de ce dernier vers un comparateur d'horloge (19)
et ce dernier vers la sortie de signal d'horloge (16),
**caractérisé en ce que**
pour former le signal d'horloge (23), un dispositif de combinaison (24) est configuré pour combiner logiquement un signal de sortie (14) du comparateur de données (11) avec un signal de sortie (22) du comparateur d'horloge (19).

13. Dispositif de décodage (4) selon la revendication 12,
**caractérisé en ce**
**qu'**une moyenne mobile d'un signal (36) dérivé du signal codé Manchester (1) peut être formée sur un temps moyen de données avec le formateur de moyenne de données mobile (9).

14. Dispositif de décodage (4) selon l'une des revendications 12 ou 13,
**caractérisé en ce**
**qu'**une moyenne mobile d'un signal (36) dérivé du signal codé Manchester (1) peut être formée sur un temps moyen d'horloge avec le formateur de moyenne d'horloge mobile (17).

15. Dispositif de décodage (4) selon l'une des revendications 12 à 14,
**caractérisé en ce**
**que** le chemin de flux de signal d'horloge (15) conduit d'une sortie de signal (39) du dispositif de combinaison (24) vers la sortie de signal d'horloge (16).

16. Dispositif de décodage (4) selon l'une des revendications 12 à 15,
**caractérisé en ce**
**que** le comparateur de données (11) est configuré pour délivrer un signal de sortie (14) en fonction d'un dépassement ou d'un passage sous au moins une valeur seuil de données (12, 13), en particulier pour délivrer un signal de sortie (14) en fonction d'un dépassement d'une valeur seuil de données supérieure (13) de ladite au moins une valeur seuil de données (12, 13)
et/ou
d'un passage sous une valeur seuil de données inférieure (12) de ladite au moins une valeur seuil (12, 13).

17. Dispositif de décodage (4) selon l'une des revendications 12 à 16,
**caractérisé en ce**
**que** le comparateur d'horloge (19) est configuré pour délivrer un signal de sortie (22) en fonction d'un dépassement ou d'un passage sous au moins une valeur seuil d'horloge (20, 21), en particulier pour délivrer un signal de sortie (22) en fonction d'un dépassement d'une valeur seuil d'horloge supérieure (21) de ladite au moins une valeur seuil d'horloge (20, 21)
et/ou
d'un passage sous une valeur seuil d'horloge inférieure (20) de ladite au moins une valeur seuil d'horloge (20, 21).

18. Dispositif de décodage (4) selon l'une des revendications 12 à 17,
**caractérisé en ce**
**qu'**il est configuré pour la formation simultanée et/ou parallèle dans le temps des moyennes de données mobile (10) et/ou d'horloge mobile (18),
en particulier dans lequel la moyenne de données mobile (10) et/ou la moyenne d'horloge mobile (18) peut/peuvent être formée(s) à une fréquence d'échantillonnage qui est chaque fois inférieure au ou à un temps de bit, en particulier inférieure à un dixième ou un centième, du ou d'un signal d'horloge (3) du signal codé Manchester (1),
et/ou
**qu'**il est configuré pour la formation simultanée de la moyenne de données mobile (10) et/ou de la moyenne d'horloge mobile (18) avec la mise à disposition d'autres symboles du signal codé Manchester (1).
